# EUROPÄISCHE PATENTANMELDUNG

(11) **EP 2 544 222 A1**
(43) Veröffentlichungstag der Anmeldung: **09.01.2013**
(21) Anmeldenummer: 12187207.1
(22) Anmeldetag: 29.07.2008
(51) Int. Cl.: H01L 21/20, H01L 21/208, H01L 21/36, H01L 21/02, H01L 31/0352, H01L 31/18

(54) **Halbleiterbauteil mit polykristalliner Halbleiterschicht**

(30) Priorität: 18.10.2007 DE 102007050288
(62) Teilanmeldung aus: 08785186.1
(71) Anmelder: Dritte Patentportfolio Beteiligungsgesellschaft mbH & Co. KG, 12529 Schönefeld / Waltersdorf (DE)
(72) Erfinder: Frey, Hartmut, 73730 Esslingen (DE); Hause, Otto, 73732 Esslingen (DE)
(74) Vertreter: Zech, Stefan Markus

(57) **Zusammenfassung**

Ein Halbleiterbauelement weist einen Träger auf und auf einer Seite des Trägers wenigstens eine Halbleiterschicht, die polykristallin ausgeführt ist. Die polykristalline Halbleiterschicht enthält die Kristallisationskeime.

## Beschreibung

In dem Maße, in dem der Bedarf an elektronischen Geräten steigt, steigt auch der Bedarf an Halbleiterbauelementen. Hierzu gehören die Grundbauteile oder Waver, aus denen integrierte Schaltkreise oder Einzelbauelemente hergestellt werden, ebenso wie Solarzellen zur Gewinnung von Strom aus Licht.

Bislang wurden bei der Herstellung beispielsweise in Epitaxieverfahren Kristallschichten aus Halbleitermaterial auf Substrat aufgewachsen. Dieses Herstellungsverfahren ist zeitaufwändig und muss in der Regel im Vakuum durchgeführt werden.

Ausgehend hiervon ist es Aufgabe der Erfindung ein neues Bauteil zu schaffen, bei dem die polykristallinen Halbleiterschichten großtechnisch leichter herstellbar sind.

Ferner ist es Aufgabe der Erfindung ein geeignetes Herstellungsverfahren für das erfindungsgemäße Bauteil zu schaffen

Diese Aufgabe wird erfindungsgemäß durch ein Bauteil mit den Merkmalen des Anspruches 1 gelöst. Ferner wird die Aufgabe durch ein Verfahren gemäß dem Anspruch 18 gelöst.

Das Bauteil weist einen Träger mit einer Oberfläche auf. Auf wenigstens einem Teil der Oberfläche befindet sich eine polykristalline Schicht aus Halbleitermaterial. Die polykristalline Schicht enthält eine Vielzahl von diffus verteilten Kristallisationskeimen. Hierdurch wird eine schnelle Kristallisation erreicht, während die diffus verteilten Kristallisationskeime die elektrische Eigenschaft der polykristallinen Schicht nicht beeinträchtigen.

Der Träger kann bevorzugt aus einem Material bestehen, das bei Temperaturen zwischen 800°C und 900°C formstabil ist. Dieser Temperaturbereich ist vorteilhaft, weil in diesem Temperaturbereich die Kristallisation in der Umgebung der Kristallisationskeime schnell fortschreitet, bis die gesamte aufgebrachte Beschichtung durchkristallisiert ist. Dieser Vorgang geht verhältnismäßig schnell, weil in der gesamten aufgebrachten Masse die Kristallisationskeime gleichmäßig diffus verteilt sind. Ferner ist diese Temperatur vorteilhaft weil der Halbleiterspender thermisch dissoziiert und das Halbleitermaterial atomar freisetzt.

Bei dem neuen Bauteil braucht das Aufbringen der Halbleiterschicht nicht im Vakuum zu erfolgen, sondern es genügt eine Schutzgasatmosphäre.

Geignete Materialien für den Träger können Edelstahl (Chromnickelstahl), Glas oder Karbon oder vergleichbare Materialien sein.

Der Träger kann platten- oder folienförmig sein. Er kann auch von einem textilen Flächengebilde gebildet sein, oder linienförmige Gestalt haben.

Je nach Material des Trägers ist es zweckmäßig, wenn zwischen dem Träger und der ersten Schicht aus polykristallinem Halbleitermaterial eine Diffusionssperrschicht implementiert ist. Als Material kommt hierfür Molybdän in Frage.

Das Grundmaterial für die polykristalline Halbleiterschicht kann ein Stoff sein, der sich als Spender für das Halbleitermaterial eignet, beispielsweise ein flüssiges oder gasförmiges Silan, wenn es um Siliziumhalbleiterschichten geht, oder German, falls die Schicht polykristallines Germanium sein soll.

Die polykristalline Halbleiterschicht kann im Übrigen auch noch durch entsprechende Dotierungsatome p- oder n-leiten ausgeführt sein.

Die Kristallisationskeime können aus demselben Material bestehen, wie der Hauptbestandteil der polykristallinen Halbleiterschicht, also beispielsweise Silizium im Falle einer Siliziumschicht, oder auch aus einem anderen Material, das als Kristallisationskeim für das gewünschte Material wirkt. Hier käme auch Germanium in Frage.

Das Bauteil kann auch mehrere Schichten aus polykristallinem Halbleitermaterial enthalten, die gestapelt übereinander liegen. Auf diese Weise können großflächige Halbleiterbauelemente geschaffen werden, beispielsweise entsprechend große Fotodioden, die sich als Solarzellen eignen. Die Halbleiterschichten werden nach demselben Verfahren nacheinander aufgebracht und weisen demzufolge dieselbe Nanostruktur auf.

In diesem Falle ist die eine Schicht p-leitend und die andere Schicht n-leitend dotiert, um den erforderlichen pn-Übergang zu schaffen.

Das Bauteil kann auf der von dem Träger wegweisenden Seite jener Halbleiterschicht, die vom Träger am weitesten entfernt ist, mit einer Schicht versehen sein, die eigenleitend bzw. metallisch leitend ist.

Beispielsweise bei der Anwendung des Bauteils als Solarzelle ist es zweckmäßig, wenn der Träger auf.beiden Seiten nach Art einer Fotodiode/Fotoelements beschichtet ist. Im Einsatzfall erhält die eine Seite direktes Sonnenlicht, während die andere Seite das diffuse Licht aus der Umgebung bekommt, wodurch insgesamt der Wirkungsgrad gesteigert ist.

Die Dichte der Kristallisationskeime liegt in der Grö-βenordnung von 100 bis 100 000 Partikeln pro mm³ Halbleiterschicht, je nach Parikelgröße.

Gemäß einem weiteren Aspekt der Erfindung besteht, wie oben ausgeführt, die Aufgabe darin, ein Verfahren anzugeben, um das erfindungsgemäße Bauteil herzustellen.

Bei dem Verfahren ist vorgesehen, dass auf den Träger ein Aerosol oder eine Suspension aufgebracht wird, die sich aus Kristallisationskeimen und einem Fluid in Form einer Flüssigkeit oder eines Gases zusammensetzt. In dem Fluid ist das gewünschte Halbleitermaterial chemisch gebunden. Nach dem Aufbringen des Aerosols oder der Emulsion auf den Träger wird die entstandene Schicht thermisch behandelt, um die polykristalline Schicht zu erzeugen. Dabei wird der chemische Stoff, der das Halbleitermaterial enthält, dazu gebracht, dass Halbleitermaterial in atomarer Form frei zu geben, damit es sich um die Kristallisationskeime herum als kristallförmig abscheiden kann.

Als Fluid in gasförmiger oder in flüssiger Form eignen sich Silane bzw. entsprechende Germane, aus denen das Silizium/Germanium als Atom zur Kristallisation abgegeben werden kann.

Die Kristallisationskeime können eine Größe haben zwischen 100 nm und 10000 nm, vorzugsweise 500 nm und 2000 nm, noch weiter bevorzugt 700 nm und 1400 nm.

Als Material für den Träger kommt jedes Material in Frage, das bei der erforderlichen Kristallisationstemperatur hinreichend formstabil ist. Beispiele für geeignete Materialien sind Edelstahl (Chromnickelstahl), Kohlenstoff, Glas und vergleichbares.

Der Träger kann flächenförmig oder linienförmig sein oder auch ein textiles Flächengebilde wie ein Gewebe, ein Gestrick oder Gewirke. Auch ein Vlies kommt in Frage.

Das oben beschriebene Verfahren kann zur Erzeugung von mehreren übereinander liegenden Schichten mehrfach angewendet werden. Dabei ist es möglich, dem Aerosol oder dem Fluid Dotierungsstoffe beizugeben, um eine p-leitende oder eine n-leitende Halbleiterschicht zu erzeugen.

Um die Kristallisationskeime zu erzeugen kann das Grundmaterial in einer Kugelmühle entsprechend fein gemahlen werden.

Im Übrigen sind Weiterbildungen der Erfindung Gegenstand von Unteransprüchen.

Die nachfolgende Figurenbeschreibung erläutert Aspekte zum Verständnis der Erfindung. Weitere, nicht beschriebene Details kann der Fachmann in gewohnter Weise der Zeichnung entnehmen, die insoweit die Figurenbeschreibung ergänzt. Es ist klar, das eine Reihe von Abwandlungen möglich sind. Die genaue Dimensionierung kann der Fachmann ohne weiteres empirisch aufgrund der angegebenen Daten vornehmen.

In der Zeichnung ist ein Ausführungsbeispiel des Gegenstandes der Erfindung dargestellt:
- Fig. 1: zeigt den Aufbau eines erfindungsgemäßen Bauteils mit lediglich einer einzigen Halbleiterschicht, im Qüerschnitt.
- Fig. 2: zeigt ein erfindungsgemäßes Bauteil mit zwei Fotodiodenstrukturen auf beiden Seiten des Trägers.
- Fig. 3: zeigt ein Beispiel für einen Träger aus einem textilen Flächenmaterial.
- Fig. 4: zeigt stark schematisiert eine Anlage zur Durchführung des erfindungsgemäßen Verfahrens zum Erhalten des erfindungsgemäßen Bauteils.

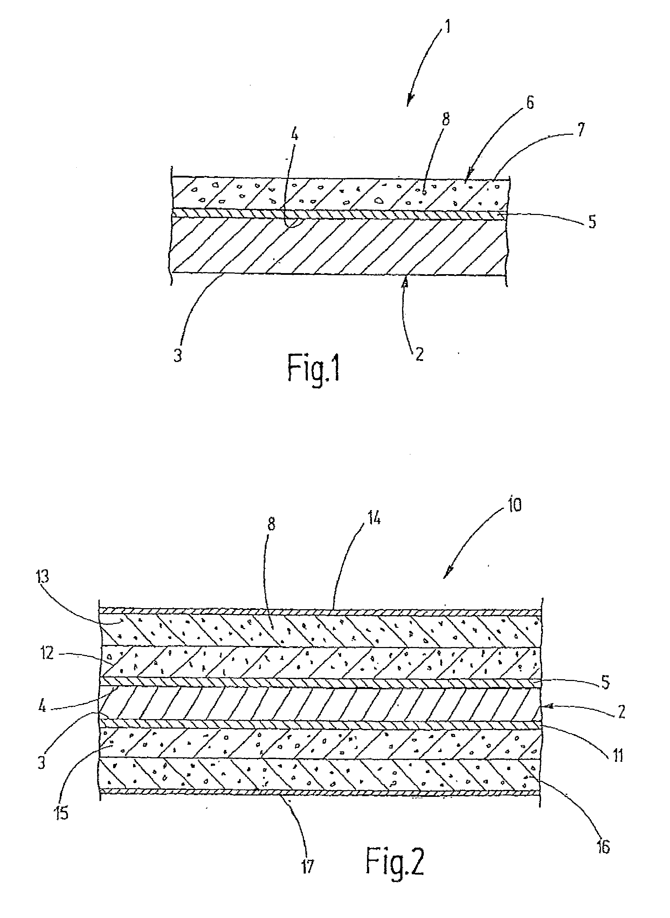

Fig. 1 zeigt in einer stark schematisierten Darstellung einen Ausschnitt aus einem erfindungemäßen Halbleiterbauteil. Das Halbleiterbauteil 1 weist einen beispielsweise bandförmig und damit endlosen Träger 2 auf. Der Träger 2 kann aus einem metallisch leitenden Material genügend Temperaturfestigkeit bestehen, beispielsweise aus Chromnickelstahl. Der bandförmige Träger 2 wird von zwei Flachseiten 3 und 4 begrenzt, die parallel und im Abstand zueinander verlaufen. Beispielsweise auf der Flachseite 4 befindet sich eine Diffusionssperrschicht 5 (ca. 200 nm dick) in Gestalt einer Molybdänschicht. Die Molybdänschicht ist elektrisch leitend so dass der elektrische Kontrakt zu dem Substrat 2 nicht verhindert wird.

Auf der Molybdänschicht 5 befindet sich eine dünne halbleitende Schicht 6. Die halbleitende Schicht 6 besteht aus polykristallinem Silizium 7 (ca. 30 µm bis 100 µm dick), in das es Kristallisationskeime 8 diffus und gleichmäßig verteilt eingebettet sind. Die Kristallisationskeime 8 sorgen dafür, dass das aufgebrachte atomare Silizium, das beispielsweise aus einem Siliziumspender wie Silan atomar abgegeben wird, um die Kristallisationskeime 8 herum poly- - kristallin auskristallisiert.

zufolge der Kristallisationskeime, die diffus verteilt sind, läuft der Kristallisationsvorgang vergleichsweise schnell ab, weil es viele Oberflächen gibt, an denen die Kristallisation beginnt.

Auf die späteren Halbleitereigenschaften haben die Kristallisationskeime 8, die aus demselben Grundmaterial bestehen wie die Halbleiterschicht selbst, keinen Einfluss.

Das Herstellungsverfahren ist weiter unten anhand von Fig. 5 näher erläutert.

Anstelle des Trägers aus Edelstahl kann auch ein Träger aus Kohlenstofffolie, Glas oder einer anderen hinreichend temperaturfesten Folie verwendet werden. Sollte eine Folie verwendet werden, die elektrisch nicht leitend ist, kann zwischen der Diffusionssperrschicht 5 und dem Träger 2 eine metallisch leitende Schicht eingefügt werden. Diese metallisch leitende Schicht mit einer Stärke von ca. 500 nm kann durch jedes bekannte Verfahren auf dem Träger 2 erzeugt werden. Das Aufbringen der metallischen Schicht ist nicht Gegenstand der vorliegenden Erfindung und braucht deswegen hier im Einzelnen nicht erläutert zu werden. Wenn keine Diffusion zu befürchten ist kann die Diffusionssperrschicht auch weggelassen werden.

Fig. 2 zeigt ein mehrschichtiges Halbleiterbaulelement in Gestalt einer mehrschichtigen flächigen Fotodiode/Fotoelement, wie sie verwendet wird, um aus Sonnenlicht Strom zu erzeugen. Das insgesamt mit 10 bezeichnete Halbleiterbauelement weist wiederum den bandförmigen Träger 2 auf, der aus Chromnickelstahl besteht. Auf der Seite 4 befindet sich, wie zuvor beschrieben, eine Molybdänschicht 5 als Diffusionssperrschicht. Eine weitere Diffusionssperrschicht 11 ist auf der gegenüberliegenden Flachseite 3 vorhanden. Auf der von dem Träger 2 abliegenden Flachseite der Diffusionssperrschicht 5 befindet sich eine'erste, beispielsweise n-leitend dotierte Halbleiterschicht 12 mit darin enthaltenen Kristallisationskeimen 8. Auf der n-leitenden Halbleiterschicht 12 ist eine p-leitende Halbleiterschicht 13 aufgebracht, die ebenfalls wiederum eine Vielzahl von homogen verteilten Kristallisationskeimen 8 enthält.

Auf der von dem Träger 2 abliegenden Seite der Halbleiterschicht 13 befindet sich eine dünne metallische Schicht 14, die die Funktion einer Elektrode für die Fotodiode aus den beiden Schichten 12 und 13 hat.

Auf der in Fig. 2 nach unten zeigenden Seite befindet sich eine ähnliche Struktur, bestehend aus einer n-leitenden Halbleiterschicht 15, die unmittelbar auf der Diffusionssperrschicht 11 aufliegt, sowie einer p-leitenden Halbleiterschicht 16. Den Abschluss nach unten bildet wiederum eine metallisch leitende Schicht 17, die als Elektrode für die untere flächige Fotodiode dient. Die andere Elektrode wird für beide Fotodioden gemeinsam von dem Träger 2 gebildet.

Aufgrund dieser Dotierung ist bei dem Halbleiterbauelement 10 die Anode durch die Schicht 13 und die Kathode durch die Schicht 12 auf der einen Seite und auf der anderen Seite die Anode durch die Schicht 16 und die Kathode durch die Schicht 15 gebildet. Bei Beleuchtung mit Licht entsteht somit an der Anode der Pluspol der Spannungsquelle und an der Schicht 8 und damit an dem Träger 2 der Minuspol.

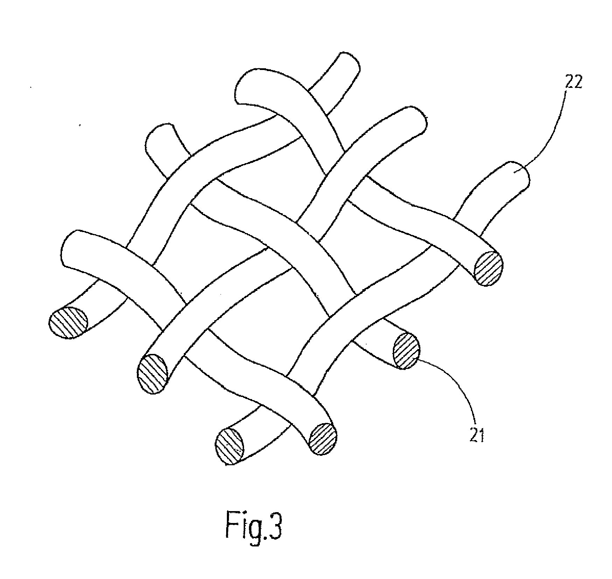

Das erfindungsgemäße Halbleiterbauteil 1 bzw. 10 ist anhand eines folienförmigen Trägers 2 in Gestalt des dünnen Edelstahlblechs oder einer Kahlenstofffolie erläutert. Als weiteres Material für den Träger 2 kommt Glas, also Siliziumdioxid mit entsprechenden Zuschlagstoffen in Frage. Neben folienförmigen Bauelementen können auch andere flächige Gebilde verwendet werden, wie Gewebe aus entsprechenden temperaturfesten Materialien..Ein Ausschnitt aus einem solchen Gewebe ist in Fig. 3 gezeigt. Das Gewebe zeigt Leinwandbindung und besteht aus Kett- und Schußfäden 21, 22.

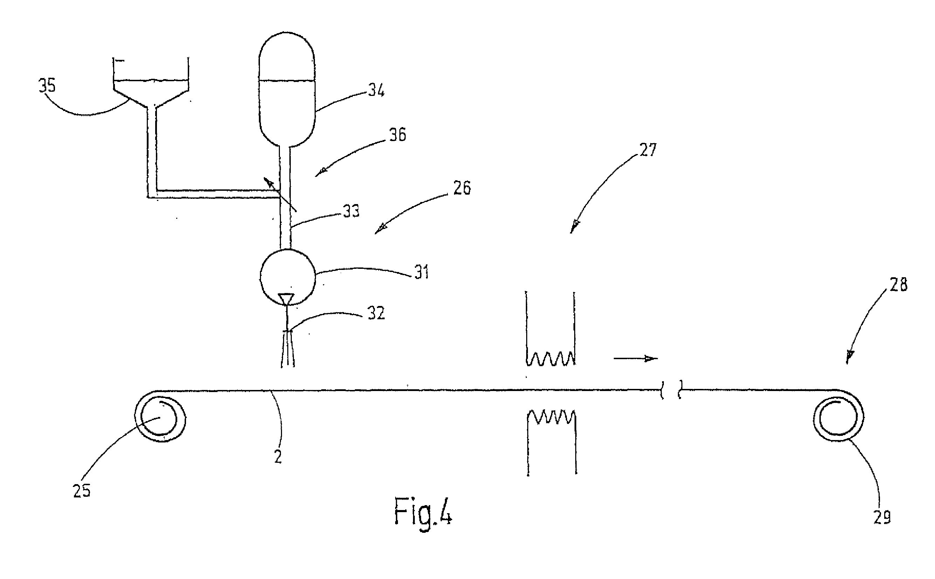

In Fig. 4 ist stark schematisiert das Herstellungsverfahren für die Halbleiterbauelemente nach den Fig. 1 und 2 gezeigt. Auf einer Vorratsrolle 25 ist der beispielsweise mit der bereits beidseitig mit Diffusionssperrschicht 5 versehene Träger 2 aufgerollt. Von hier aus läuft der Träger 2 zunächst durch eine Sprühstation 26 und anschließend durch eine Heizstation 27 ehe er bei 28 wieder zu einer Rolle 29 aufgerollt wird.

Die Sprühstation 26 ist stark schematisiert gezeigt und enthält eine Pumpe 31, deren Druck- oder Auslassseite an eine Sprühdüse 32 angeschlossen ist. Eingangsseitig ist die Pumpe 31 über ein Leitungssystem 33 mit einem Flüssigkeitsbehälter 34 und einem Pulverbehälter 35 verbunden. In dem Flüssigkeitsbehälter 34 befindet sich jene chemische Verbindung, die als Spender für das Halbleitergrundmaterial in Frage kommt. Hierbei kann es sich beispielsweise um flüssiges Silan oder flüssiges German handeln.

In dem Pulverbehälter 35 sind die Kristallisationskeime in Gestalt von entsprechendem Pulver enthalten. Geeignete Kristallisationskeime sind fein gemahlenes Silizium oder Germanium. Das Pulver kann aus Reinsilizium oder Reingermanium in Kugelmühlen erzeugt werden, wie dies dem Fachmann bekannt ist.

An einer Mischungsstelle 36, die regelbar ist, wird das aus dem Behälter 35 kommende Pulver entsprechend dosiert dem vorbei strömenden Silan oder German aus dem Behälter 34 beigemischt. Die enthaltene Mischung aus Flüssigkeit und Festkörperpulver gelangt in die Pumpe 31 und wird über die Düse 32 auf die benachbarte Oberseite des mit der Diffusionssperrschicht 5 versehenen Trägers aufgesprüht. Wegen der Größenverhältnisse ist in Fig. 4 die bereits vorhandene Diffusionssperrschicht nicht zu erkennen.

Die aufgesprühte Suspension bildet auf der nach oben zeigenden Seite des beschichteten Trägers 2 eine dünne Flüssigkeitsschicht mit homogener Dicke.

Da das Band mit konstanter Geschwindigkeit von der Rolle 25 zu der Rolle 29 läuft, entsprechend der Richtung des dargestellten Teils, wird nacheinander die gesamte Länge des Trägers 2 auf der betreffenden Seite mit der Suspension besprüht.

Nachdem die Suspension auf den Träger 2 bzw. die freie Seite des entsprechend vorher beschichteten Trägers aufgebracht ist, gelangt der entsprechende Längenabschnitt des Trägers 2 in die Heizstation 27. In der Heizstation wird der durchlaufende Bereich des Trägers 2 mit der darauf befindlichen Suspension auf eine Temperatur oberhalb von 800°C und unterhalb von 900°C aufgeheizt. Bei dieser Temperatur tritt eine thermische Dissoziation des Silans oder Germans auf. Das chemisch gebundene Silizium oder Germanium wird freigesetzt, während die Restbestandteile verdampfen. Zufolge der enthaltenen Kristallisationskeime in Gestalt des gemahlenen Halbleiterpulvers aus dem Behälter 35 setzt umgehend um die Kristallisationskeime 8 herum eine Kristallisation ein, so dass sich die ursprüngliche flüssige Suspensionsschicht in eine polykristalline Halbleiterschicht umwandelt.

Der einhergehende Verdunstungsprozess der flüchtigen Bestandteile aus dem Silan bzw. German beeinträchtigt die Kristallisation nicht und führt auch nicht zu Fehlstellen in der Schicht.

Nachdem die Kristallisation abgelaufen ist und der Träger 2 mit der darauf enthaltenen Halbleiterschicht hinreichend abgekühlt ist, wird er bei 28 zur Rolle 29 wieder fortlaufend aufgewickelt.

Nach dem ersten erfindungsgemäßen Schritt wird ein Träger 2 erhalten, der auf der bearbeiteten Seite oberhalb der Diffusionssperrschicht eine Halbleiterschicht enthält. Die Stärke der Halbleiterschicht kann durch die Dicke der Suspensionsschicht in weiten Grenzen variiert werden. Diese wiederum ist von der Tröpfchengröße, der Sprühmenge und der Laufgeschwindigkeit des Trägers 2 vor der Düse 32 abhängig.

Nachdem auf die beschriebene Weise die erste Halbleiterschicht aufgebracht ist, kann die erhaltene Rolle 29 auf die linke Seite der Anordnung gebracht werden und eine neue Rolle 25 bilden, mit einem Träger, der bereits eine erste Halbleiterschicht trägt. Der zuvor beschriebene Beschichtungsprozess mit der Suspension und der anschließenden Kristallisation in der Heizstation 27 wird ein zweites Mal durchlaufen. Hierdurch wird auf dem Träger, der nun durch die Sprühstation 26 hindurch läuft und der bereits die Diffusionssperrschicht sowie die erste Halbleiterschicht entsprechend der Halbleiterschicht 12 aus der Darstellung von Fig. 2 trägt, mit einer weiteren Suspensionsschicht versehen, die anschließend, wie zuvor beschrieben, in der Heizstation 27 dazu gebracht wird, sich polykristallin in einer Halbleiterschicht entsprechend der Halbleiterschicht 13 nach Fig. 2 umzuwandeln. Nach dem zweiten Durchgang enthält die Rolle 29 einen Träger 2, auf dem sich die Diffusionssperrschicht 5, die Halbleiterschicht 12 und die Halbleiterschicht 13 befinden.

Die beschriebenen Vorgänge können mit der gegenüberliegenden Seite des Trägers 2, die in Fig. 4 nach unten zeigt in der gleichen Weise auch mehrfach durchgeführt werden, so dass schlussendlich ein bandförmiges Gebilde entsteht, das auf beiden Seiten mit zwei übereinander gestapelten Halbleiterschichten versehen ist.

In einer alternativen Ausführungsform können auch sämtliche Prozessschritte, die die vier Halbleiterschichten erzeugen, nacheinander ausgeführt werden und erst anschlie-βend wird der Strang aufgewickelt. Am Schluss trägt der bandförmige Strang vor dem endgültigen Aufwickeln bereits sämtliche Halbleiterschichten 12, 13, 15 und 16 trägt.

Das Aufsprühen der Suspension und das Aufheizen in der Heizstation 27 erfolgt jeweils unter Schutzgasatmosphäre bei Normaldruck. Problematischen Abdichtungen sind nicht erforderlich und es ist auch nicht erforderlich das Aufwickeln und das Abwickeln jeweils ebenfalls.unter Schutzgasatmosphäre durchführen zu müssen, wie wohl dies im Schutz der Halbleiterschicht zweckmäßig sein kann.

Um die unterschiedlichen-Leitungstypen der Halbleiterschichten zu erzeugen, ist ein Dotierungsstoff erforderlich. Diese Dotierungsstoffe sind bei Fotodioden bzw. Fotoelementen Gallium und Arsen. Mit Hilfe von Gallium wird eine p-leitende und mit Hilfe von Arsen eine n-leitende Schicht erzeugt. Diese Stoffe können entweder separat aus einem eigenen Behälter der Mischstation 36 zugeführt werden, oder sie können bereits in das Silan 34 eingemischt sein oder sie können in pulverförmiger Form in dem Behälter 35 mit den Kristallisationskeimen enthalten sein.

Die Anzahl der Halbleiterschichten, die auf die beschriebene Weise übereinander gestapelt werden können, ist nicht begrenzt. Ebenso ist es möglich, die erzeugte Halbleiterschicht ohne Dotierungsatome zu erzeugen und anschließend nach der Polykristallisation mit Hilfe von Ionenimplatation den entsprechenden Leitungstyp zu erzeugen.

Das beschriebene Verfahren ist nicht auf die Verwendung von entweder Silan oder German beschränkt. Vielmehr kann bei dem Verfahren auch eine beliebige Mischung aus German und Silan verwendet werden um eine Mischkristallschicht aus Germanium und Silizium zu erhalten. Das Mischungsverhältnis ist beliebig und richtet sich nach den gewünschten elektrischen Eigenschaften. Die Kondensationskeime sind auch bei der Mischung aus Silan und German silizium oder Germanium oder eine Mischung aus beiden Elementen.

Schließlich ist es denkbar auf dem Träger 3-schichtige Strukturen für Transistoren zu erzeugen, die nachträglich durch bekannte Verfahren voneinander getrennt und kontaktiert werden, um eine großflächige Dünnfilmtransistorstruktur zu schaffen. Eine weitere Struktur, die möglich ist, besteht darin, die Transistorstruktur mit einer Leuchtdiodenstruktur zu kombinieren um so genannten TFT-Bauteile zu erhalten.

Ebenfalls ist es denkbar, diese Struktur zu verwenden um flächig leuchtende Halbleiterbauelemente zu schaffen.

Ein Halbleiterbauelement weist einen Träger auf und auf einer Seite des Trägers wenigstens eine Halbleiterschicht, die polykristallin ausgeführt ist. Die polykristalline Halbleiterschicht enthält die Kristallisationskeime.

## Patentansprüche

1. Bauteil
mit einem Träger (2), der eine Oberfläche (3,4) aufweist, und
mit wenigstens einer polykristallinen Schicht (6,12,13,15,16) aus Halbleitermaterial auf wenigstens einem Teil der Oberfläche (3,4),
wobei die polykristalline Schicht (6,12,13,15,16) eine Vielzahl von diffus verteilten Kristallisationskeimen (8) enthält.

2. Bauteil nach Anspruch 1, **dadurch gekennzeichnet, dass** der Träger (2) aus einem Material besteht, das bei Temperaturen zwischen 800°C und 900°C formstabil ist.

3. Bauteil nach Anspruch 1, **dadurch gekennzeichnet, dass** der Träger (2) aus Edelstahl, Glas oder Karbon besteht.

4. Bauteil nach Anspruch 1, **dadurch gekennzeichnet, dass** der Träger (2) platten- oder folienförmig ist.

5. Bauteil nach Anspruch 1, **dadurch gekennzeichnet, dass** der Träger (2) von einem textilen Flächengebilde gebildet ist.

6. Bauteil nach Anspruch 1, **dadurch gekennzeichnet, dass** der Träger (2) linienförmig ist.

7. Bauteil nach Anspruch 1, **dadurch gekennzeichnet, dass** zwischen dem Träger (2) und der unmittelbar benachbarten polykristallinen Schicht (6, 12, 13, 15, 16) aus Halbleitermaterial eine Diffusionssperrschicht (5, 11) enthalten ist.

8. Bauteil nach Anspruch 7, **dadurch gekennzeichnet, dass** die Diffusionssperrschicht (5,11) von Molybdän gebildet ist.

9. Bauteil nach Anspruch 1, **dadurch gekennzeichnet, dass** die polykristalline Schicht (6, 12, 13, 15, 16) aus Halbleitermaterial Silizium oder Germanium oder eine Mischung aus Silizium und Germanium enthält.

10. Bauteil nach Anspruch 1, **dadurch gekennzeichnet, dass** die polykristalline Schicht (6,12,13,15,16) aus Halbleitermaterial p- oder n-leitend dotiert ist.

11. Bauteil nach Anspruch 1, **dadurch gekennzeichnet, dass** die Kristallisationskeime (8) aus demselben Material bestehen, wie die polykristalline Halbleiterschicht (6,12,13,15,16) selbst.

12. Bauteil nach Anspruch 1, **dadurch gekennzeichnet, dass** die Kristallisationskeime (8) aus einem anderen Halbleitermaterial bestehen als die polykristalline Schicht (6, 12, 13, 15, 16) selbst.

13. Bauteil nach Anspruch 1, **dadurch gekennzeichnet, dass** die Kristallisationskeime (8) Germanium oder Siliziumpartikel sind.

14. Bauteil nach Anspruch 1, **dadurch gekennzeichnet, dass** die Partikelgröße der Kristallisationskeime (8) zwischen 100 nm und 10000 nm liegt, vorzugsweise im Bereich zwischen 500 nm und 2000 nm, weiter bevorzugt zwischen 700 nm und 1400 nm.

15. Bauteil nach Anspruch 1, **dadurch gekennzeichnet, dass** das Bauteil (1,10) wenigstens zwei übereinander gestapelte polykristalline Schichten (6, 12, 13, 15, 16) aus Halbleitermaterial mit unterschiedlichem Leitungstyp aufweist.

16. Bauteil nach Anspruch 1, **dadurch gekennzeichnet, dass** die von dem Träger (2) wegweisende Seite der vom Träger (2) am weitesten entfernt liegenden Halbleiterschicht (13, 16) mit einer lichtdurchlässigen elektrisch leitenden Schicht (14,17) versehen ist, die keine Halbleitereigenschaft aufweisen.

17. Bauteil nach Anspruch 1, **dadurch gekennzeichnet, dass** der Träger (2) flächig ist und zwei Flachseiten aufweist, wobei beide Seiten (3,4) mit wenigstens einer polykristallinen Schicht (6, 12, 13, 15, 16) aus Halbleitermaterial versehen ist und die polykristallinen Schichten (6, 12, 13, 15,16) diffus verteilte Kondensationskeime (8) enthalten.

18. Bauteil nach Anspruch 1, **dadurch gekennzeichnet, dass** die Dichte an Kristallisationskeimen (8) über die Erstreckung der polykristallinen Schicht (6, 12, 13, 15, 16) aus Halbleitermaterial homogen ist.

19. Verfahren zum Herstellen eines Bauteils nach Anspruch 1, bei dem auf den Träger (2) eine Suspension aufgebracht wird, die sich aus Kristallisationskeimen (8) und einem Fluid in Form einer Flüssigkeit oder eines Gases zusammensetzt, die das gewünschte Halbleitermaterial chemisch gebunden hält, wobei nach dem Aufbringen des Aerosols oder der Emulsion auf den Träger (2) die entstandene Schicht (6,12,13,15,16) thermisch behandelt wird, um die polykristalline Schicht (6, 12, 13, 15, 16) zu erhalten.

20. Verfahren nach Anspruch 19, **dadurch gekennzeichnet, dass** das Fluid ein Silan oder German oder eine Mischung aus Silan und German ist.

21. Verfahren nach Anspruch 19, **dadurch gekennzeichnet, dass** die Kristallisationskeime (8) eine Partikelgröße zwischen 100 nm und 10000 nm, vorzugsweise zwischen 500 nm und 2000 nm, noch weiter bevorzugt zwischen 700 nm und 1400 nm aufweisen.

22. Verfahren nach Anspruch 19, **dadurch gekennzeichnet, dass** die Kristallisationskeime (8) aus den Stoffen wie Silizium oder Germanium ausgewählt sind.

23. Verfahren nach Anspruch 19, **dadurch gekennzeichnet, dass** der Träger (2) ein Träger ist, der bei der Kristallisationstemperatur formstabil bleibt.

24. Verfahren nach Anspruch 19, **dadurch gekennzeichnet, dass** der Träger (2) Edelstahl oder Kohlenstoff oder Glas ist.

25. Verfahren nach Anspruch 19, **dadurch gekennzeichnet, dass** der Träger (2) flächenförmig oder linienförmig ist.

26. Verfahren nach Anspruch 19, **dadurch gekennzeichnet, dass** das Verfahren nach Anspruch 19 wenigstens ein zweites mal wiederholt wird, um eine weitere polykristalline Schicht (6, 12, 13, 15, 16) aufzubringen.

27. Verfahren nach Anspruch 19, **dadurch gekennzeichnet, dass** das Material, 1 aus dem die Kristallisationskeime hergestellt werden, in einer Kugelmühle gemahlen wird.
